# EUROPÄISCHE PATENTSCHRIFT

(11) **EP 2 885 824 B1**
(45) Veröffentlichungstag und Bekanntmachung des Hinweises auf die Patenterteilung: **23.08.2017**
(21) Anmeldenummer: 13762792.3
(22) Anmeldetag: 11.09.2013
(51) Int. Cl.: H01L 51/00, H01L 51/30

(54) **SALZE DES CYCLOPENTADIENS ALS N-DOTIERSTOFFE FÜR DIE ORGANISCHE ELEKTRONIK**
SALTS OF CYCLOPENTADIENE AS N-DOPANTS FOR ORGANIC ELECTRONICS
SELS DE CYCLOPENTADIÈNE EN TANT QUE SUBSTANCES DOPANTES N POUR L'ÉLECTRONIQUE ORGANIQUE

(30) Priorität: 27.09.2012 DE 102012217587
(43) Veröffentlichungstag der Anmeldung: 24.06.2015
(73) Patentinhaber: Siemens Aktiengesellschaft, 80333 München (DE)
(72) Erfinder: SCHMID, Günter, 91334 Hemhofen (DE); WEMKEN, Jan Hauke, 90449 Nürnberg (DE)
(86) Internationale Anmeldenummer: PCT/EP2013/068785
(87) Internationale Veröffentlichungsnummer: WO 2014/048741

(56) Entgegenhaltungen:
- US-A- 5 922 396
- US-A1- 2007 295 941
- US-A1- 2011 124 141
- RONGBEN ZHANG ET AL: "Alkali metal salts of pentaphenylcyclopentadienide", JOURNAL OF ORGANOMETALLIC CHEMISTRY, Bd. 229, Nr. 2, 20. April 1982 (1982-04-20), Seiten 109-112, XP055082575, DOI: 10.1016/S0022-328X(00)90273-0

## Beschreibung

Die vorliegende Erfindung betrifft eine organisch, elektronenleitende Schicht mit mindestens einem Dotanden zur Erhöhung der n-Leitfähigkeit der organischen Schicht, dadurch gekennzeichnet, dass der Dotand ausgewählt ist aus der Gruppe der Salze der Cyclopentadien-Verbindungen.

### Stand der Technik

Das marktgerechte Zurverfügungstellen effektiver Bauteile der organischen Elektronik verlangt neben der Auswahl hocheffizienter Einzelkomponenten auch den Einsatz von Herstelltechnologien, welche eine kostengünstige Serienproduktion ermöglichen. Dieses trifft insbesondere für organische Bauelemente wie zum Beispiel organische Leuchtdioden (OLEDs), deren Aufbau schematisch in Figur 1 dargestellt ist, organische Solarzellen, schematisch dargestellt in Figur 2 und organische Feldeffekttransistoren, dargestellt in Figur 3, zu, deren Zusammensetzung in den letzten Jahren einem auf immer höhere Leistung gerichteten Wandel unterworfen sind.

Ein Kernpunkt der Entwicklungstätigkeiten zur Effizienzsteigerung ist dabei die Etablierung einer höheren Bauteil-Güte, welche sich im Wesentlichen durch eine Erhöhung der Ladungsträgerbeweglichkeit und -dichte innerhalb der verwendeten organisch, elektrischen Transportschichten erreichen lässt.

Zur Erhöhung der Elektronenleitfähigkeit werden in der organischen Elektronik grundsätzlich zwei unterschiedliche Ansatzpunkte verfolgt. Zum einen kann eine Erhöhung der Ladungsträgerinjektion aus einem Einfügen einer Zwischenschicht zwischen Kathode und Elektronentransportschicht resultieren. Zum anderen kann eine Erhöhung der Ladungsträgerdichte durch das n-Dotieren elektrisch leitfähiger, organischer Matrixmaterialien mit geeigneten Donoren erreicht werden. Hierbei wird das Matrixmaterial entweder durch Co-Sublimation aus der Gas- oder aus einer flüssigen Phase zusammen mit dem Dotanden als Schicht abgeschieden.

Für erstgenannte Methode werden oft dünne Salzschichten aus LiF, CsF oder in der neueren Literatur Caesiumcarbonat eingesetzt, welche die Austrittsarbeit der Elektronen erniedrigen. Die Eigenschaften und Auswirkungen von Caesiumcarbonat wird dabei z.B. durch Huang, Jinsong et al., Adv. Funct. Mater. 2007, 00, 1-8.; Wu, Chih-I et al., APPLIED PHYSICS LETTERS 88, 152104 (2006) und Xiong, Tao et al., APPLIED PHYSICS LETTERS 92, 263305 (2008) beschrieben. Durch diese Zwischenschichten wird der Elektronentransport signifikant verbessert, für hocheffiziente Schichten ist diese Verbesserung jedoch unzureichend.

Zur Dotierung elektronischer Transportschichten werden allgemein Substanzen verwendet, deren HOMO (Highest Occupied Molecular Orbital) oberhalb des LUMOs (Lowest Unoccupied Molecular Orbital) des Matrixmaterials liegt. Dies ist eine Voraussetzung, um eine Elektron vom Dotanden auf das Matrixmaterial zu übertragen und so dessen Leitfähigkeit zu erhöhen. Zusätzlich werden des Weiteren bevorzugt Substanzen eingebracht, deren Valenzelektronen sehr niedrige Austrittsarbeiten beziehungsweise Ionisierungsenergien aufwiesen. Auch dieses kann die Elektronenabgabe des Dotanden erleichtern und somit die Schichtleitfähigkeit erhöhen.

Als eine Möglichkeit zur Dotierung organischer Halbleitermaterialien schlägt zum Beispiel die DE 103 38 406 A1 elektrisch neutrale Verbindungen mit spezieller Geometrie vor, wobei nach dem Einmischen des Dotanden in das organische Halbleitermaterial Wasserstoff-, Kohlenoxid-, Stickstoff-oder Hydroxy-Radikale abgespalten und zumindest ein Elektron auf oder vom Halbleitermaterial übertragen wird. Diese Verbindungen sind dadurch gekennzeichnet, dass als Dotand eine ungeladene organische Verbindung verwendet wird. Als Beispielverbindungen werden substituierte und unsubstituierte Homo- oder Heterozyklen genannt, welche durch Abgabe oder Aufnahme eines Elektrons ein aromatisches 6-n System ausbilden. Nachteilig an dieser Lösung ist, dass die Bedingungen an das Matrixmaterial zur Abspaltung eines Wasserstoffradikals vom Dotanden sehr einschränkend sind und mit den in der organischen Elektronik gebräuchlichen Matrixmaterialien äußerst selten erfüllt werden. Desweiteren sind zum Beispiel die entstehenden Wasserstoff-Radikale äußerst reaktiv, welches zu unkontrollierten Reaktionen und letztendlich zu einer Beschädigung der Schicht oder des Bauteiles führen kann.

Die US 5,922,396 A beschreibt eine Methode zur Herstellung einer Mehrschichtstruktur für die organische Elektronik, welche sowohl n(Elektronen)-leitfähige als auch p(Loch)-leitfähige Schichten enthält. Das Mehrschichtkonstrukt wird unter anderem durch Sublimation organisch metallischer Komplexe erhalten, welche in der Gasphase freie Radikale bilden und dann anschließend in dieser Form als elektronenleitende Schicht abgeschieden werden.

Weitere Möglichkeiten zum Erhalt von n-Dotanden sind beispielsweise in der US 2007 295941 A1 und der US 2011 124141 A1 beschreiben.

Es ist daher die Aufgabe der vorliegenden Erfindung organische Schichten bereitzustellen, welche sich zum Einsatz in der organischen Elektronik eignen, im Vergleich zum Stand der Technik verbesserte elektrische Eigenschaften aufweisen und welche sich zudem einfach und kostengünstig herstellen lassen.

Gelöst wird diese Aufgabe durch die Merkmale des Anspruchs 1. Besondere Ausführungsformen der Erfindung werden in den Unteransprüchen wiedergegeben.

Im Sinne der Erfindung ist demgemäß eine organische, elektronenleitende Schicht mit mindestens einem Dotanden zur Erhöhung der n-Leitfähigkeit der organischen Schicht, dadurch gekennzeichnet, dass der Dotand ausgewählt ist aus der Gruppe der Salze der Cyclopentadien-Verbindungen nach Formel 1, 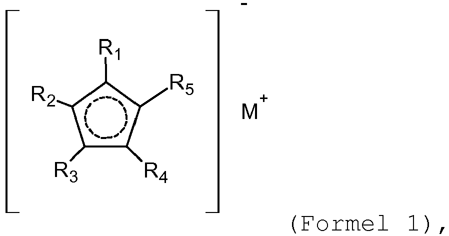 wobei M+ aus Formel 1 ausgewählt ist aus der Gruppe der Alkali-, Erdalkali-, Hauptgruppen-, Nebengruppen-, Lanthanoid-und Übergangsmetalle und die Substituenten R₁ bis R₅ unabhängig voneinander ausgewählt sind aus der Gruppe enthaltend -H, -D, Halogen, -CN, -NO₂, -OH, Amin, Ether, Thioether, Alkyl, Cycloalkyl, Acryl, Vinyl, Allyl, Aromaten, annelierte Aromaten und Heteroaromaten. Bedingt durch die chemischen Eigenschaften wird das Cyclopentadien-Derivat erst einmal als Anion in die elektronenleitende Schicht eingebaut und kann, ohne durch die Theorie gebunden zu sein, gemäß folgendem Mechanismus 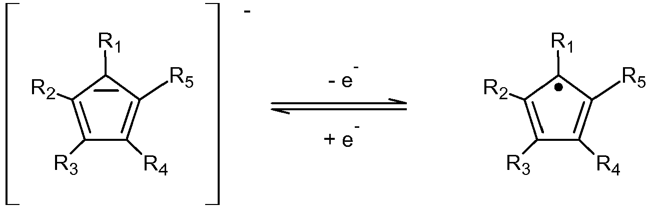 ein Elektron an das Matrixmaterial abgeben und so zur Erhöhung der Ladungsträgerdichte innerhalb der Schicht beitragen. Die erfindungsgemäßen Cyclopentadien-Anionen sind, ebenso wie die Radikale, resonanzstabilisiert und somit chemisch sehr stabil. Die Redoxreaktion erfolgt spontan und führt zu keinen unerwünschten Nebenprodukten. Eine Abspaltung von Wasserstoffradikalen kann beim Einbau der erfindungsgemäßen Dotanden in Elektronentransportmaterialien nicht beobachtet werden und ist auch nicht erfindungsgemäß, da Wasserstoffradikale bzw. deren Folgereaktionsprodukte oder daraus rekombinierende Wasserstoffmoleküle die Bauteile schädigen können. Bedingt durch das erfindungsgemäße Substitutionsmuster ergeben sich
vorteilhafte HOMO/LUMO-Lagen des Dotanden in Bezug auf im Stand der Technik bekannte Elektronentransportmaterialien.

Das Metall-Kation M⁺ aus Formel 1 kann ausgewählt sein aus der Gruppe der Alkali-, Erdalkali-, Hauptgruppen-, Nebengruppen-, Lanthanoid- und Übergangsmetalle. Besonders bevorzugt sind die Metalle der oben genannten Gruppen, welche in salzartigen Verbindungen stabile, einfach positiv geladene Kationen bilden. Diese Gruppe der Kationen führt in Verbindung mit den erfindungsgemäßen Cyclopentadien-Verbindungen zu reproduzierbar und leicht verdampfbaren Verbindungen, welche homogene Schichten mit den Elektronentransportmaterialien bilden, welches vorteilhaft in Bezug auf die Reproduzierbarkeit und die Güte der resultierenden Schichten ist.

Die einzelnen Substituenten R₁ bis R₅ können unabhängig voneinander ausgewählt sein aus der Gruppe enthaltend -H, -D, Halogen, -CN, -NO₂, -OH, Amin, Ether, Thioether, Alkyl, Cycloalkyl, Acryl, Vinyl, Allyl, Aromaten, anellierte Aromaten und Heteroaromaten. Soweit nicht allgemein dem Fachmann bekannt, können unter den Substituenten insbesondere verstanden werden:
Halogen: Cl, F
Alkyl: linear oder verzweigt Cl bis C5 Alkyl
Cycloalkyl: C3 - C8 cycloalkyl
Anellierte Aromaten: C10 - C40 Aromat
Heteroaromaten: C3-C20 mit den Heteroatomen N, O

Die Substituenten R₁ bis R₅ können zudem an jeder bindungsfähigen Stelle ihres Grundkörpers substituierte oder unsubstituierte Heterozyklen aufweisen. Vorzugsweise können die Substituenten aus substituierten und unsubstituierter Heterocyclen wie z.B. Furan, Thiophen, Pyrrol, Oxazol, Thiazol, Imidazol, Isoxazol, Isothazol, Pyrazol, Pyridin, Pyrazin, Pyrimidin, 1,3,6 Triazin, Pyrylium, alpha-Pyrone, gamma-Pyrone, Benzofuran, Benzothiophen, Indol 2H-Isoindol, Benzothiazol,2-benzothiophene, 1H-benzimidazole, 1H-benzotriazole, 1,3 benzoxazole, 2-benzofuran, 7H-purine, Chinolin, Iso-Chinolin, Quinazoline, Quinoxaline, phthalazine, 1,2,4-benzotriazine, Pyrido[2,3-d]pyrimidine, Pyrido[3,2-d]pyrimidine, pteridine, acridine, phenazine, benzo[g]pteridine, 9H-carbazole und Bipyridin und deren Derivaten ausgewählt werden.

Elektronentransportmaterialien zur Aufnahme und Weitertransport von Elektronen sind im Stand der Technik bekannt und bevorzugte Materialien können ausgewählt werden aus der Gruppe umfassend 2,2',2" -(1,3,5-Benzinetriyl)-tris(1-phenyl-1-H-benzimidazole), 2-(4-Biphenylyl)-5-(4-tert-butylphenyl)-1,3,4-oxadiazole; 2,9-Dimethyl-4,7-diphenyl-1,10-phenanthroline (BCP), 8-Hydroxyquinolinolato-lithium; 4-(Naphthalen-1-yl)-3,5-diphenyl-4H-1,2,4-triazole; 1,3-Bis[2-(2,2'-bipyridine-6-yl)-1,3,4-oxadiazo-5-yl]benzene; 4,7-Diphenyl-1,10-phenanthroline (BPhen); 3-(4-Biphenylyl)-4-phenyl-5-tert-butylphenyl-1,2,4-triazole ;Bis(2-methyl-8-quinolinolate)-4-(phenylphenolato)aluminium; 6,6'-Bis[5-(biphenyl-4-yl)-1,3,4-oxadiazo-2-yl]-2,2'-bipyridyl ;2-phenyl-9,10-di(naphthalen-2-yl)-anthracene; 2,7-Bis[2-(2,2'-bipyridine-6-yl)-1,3,4-oxadiazo-5-yl]-9,9-dimethylfluorene; 1,3-Bis[2-(4-tert-butylphenyl)-1,3,4-oxadiazo-5-yl]benzene; 2-(naphthalen-2-yl)-4,7-diphenyl-1,10-phenanthroline; 2,9-Bis(naphthalen-2-yl)-4,7-diphenyl-1,10-phenanthroline; Tris(2,4,6-trimethyl-3-(pyridin-3-yl)phenyl)borane; 1-methyl-2-(4-(naphthalen-2-yl)phenyl)-1H-imidazo[4,5-f][1,10]phenanthroline; Phenyl-dipyrenylphosphine oxide; Naphtahlintetracarbonsäuredianhydrid bzw. dessen Imide; Perylentetracarbonsäuredianhydrid bzw. dessen Imide; Materialien basierend auf Silolen mit einer Silacyclopentadieneinheit oder weitere Heterozyklen wie in der EP 2 092 041 B1 beschrieben.

In einem weiteren Aspekt der Erfindung kann die organische, elektronenleitende Schicht einen Dotanden enthalten, wobei der Dotand ausgewählt ist aus der Gruppe der nichtsubstituierten oder substituierten Pentaarylcyclopentadien-Salze. Gerade die Pentaarylcyclopentadien-Salze liefern aufgrund ihres Substitutionsmusters am Cyclopentadien eine besonders bevorzugte sterische Symmetrie, welches ein einfaches Sublimieren der Verbindung erlaubt. Desweiteren ist das HOMO/LUMO-Verhältnis zwischen Pentaarylcyclopentadien-Anion und Matrixmaterial dergestalt, dass eine hoch effektive Elektronenabgabe erhalten werden kann. Diese, ohne durch die Theorie gebunden zu sein, wahrscheinlich durch die ausgeprägte Resonanzstabilisierung über die gesamte aromatische Einheit. Die Arylkomponenten können zudem an jeder substitutionsfähigen Stelle ihres Ringgerüstes weitere Substituenten, wie weiter oben aufgeführt, tragen.

In einem weiteren, erfindungsgemäßen Aspekt kann die organische, elektronenleitende Schicht ein Metall-Kation M⁺ ausgewählt aus der Gruppe der Alkalimetalle umfassend Lithium, Natrium, Kalium, Rubidium und Caesium enthalten. Diese Auswahl kann besonders vorteilhaft sein, da die Löslichkeit der Alkali-Metalle, im Vergleich zu denen der anderen Metalle, in dem Matrixmaterial besser ist. Dies kann im Zusammenhang mit den erfindungsgemäßen Anionen zu einer besonders homogenen Verteilung innerhalb der Schicht und somit zu einem insgesamt homogenen Schichtaufbau führen.

In einer besonderen Ausführungsform kann die organische, elektronenleitende Schicht ein Metall-Kation M⁺ ausgewählt aus der Gruppe der schweren Alkalimetalle umfassend Rubidium und Caesium enthalten. Diese Auswahl kann besonders vorteilhaft sein, da die Löslichkeit gerade der schweren Alkali-Metalle, im Vergleich zu denen der anderen und der leichten Alkali-Metalle, in dem Matrixmaterial besser ist. Des Weiteren können die schweren Vertreter der Alkalimetalle zu Verbindungen führen, welche sich aufgrund der Größe des Metall-Kations besonders gut verdampfen lassen.

In einer besonderen Ausführungsform kann als Dotand innerhalb der elektronenleitenden, elektrischen Schicht Caesium oder Rubidium Pentaaryl-Cyclopentadienid vorliegen. Des Weiteren besonders bevorzugt ist die Verwendung von Caesium Pentaaryl-Cyclopentadienid.

In einer weiteren Ausführungsform der Erfindung kann der organische Teil des Dotanden innerhalb der organischen, elektronenleitenden Schicht mit einer Oxidationszahl von größer oder gleich -1 und kleiner oder gleich 0 vorliegen. Überraschenderweise hat sich gezeigt, dass Schichten aufweisend Dotanden mit diesem Redoxbereich des Anions langlebiger sind. Eine weitere Oxidation der organischen Verbindung innerhalb des Matrixmaterials erfolgt nicht. Ebenso lassen sich die optischen Absorptionseigenschaften des Dotanden und damit auch der Schicht durch die Auswahl geeigneter Liganden einstellen.

Ferner kann die organische, elektronenleitende Schicht mittels eines Lösemittel- oder Sublimationsprozesses auf ein Bauteil aufgebracht werden. Die erfindungsgemäßen Verbindungen können sich ohne Strukturänderung leicht verdampfen lassen und bilden über einen Sublimations- oder Lösemittelprozess zusammen mit dem Matrixmaterial sehr homogene Schichten. Dies ist für eine reproduzierbare Schichtdicke äußerst vorteilhaft und kann zu längeren Bauteilstandzeiten beitragen.

Desweiteren können in einer besonderen Ausführungsform die Salze der Cyclopentadienverbindungen mit einem Molekulargewicht größer oder gleich 175 g/mol und kleiner oder gleich 2000 g/mol und mit Sublimationstemperaturen größer oder gleich 120 °C und kleiner oder gleich 600 °C in der organischen, elektronenleitenden Schicht enthalten sein. Ohne durch die Theorie gebunden zu sein ermöglicht dieser Molekularmassenbereich eine ausreichende Größe der Substituenten um eine ausreichende Resonanzstabilisierung der Verbindung zu erreichen. Höhere Molekulargewichte als 2000 g/mol können hingegen unvorteilhaft sein, da die Sublimationstemperatur der salzartigen Verbindung als Funktion der Massenzunahme überproportional ansteigt. Im Rahmen der Verarbeitung hat sich zudem gezeigt, dass Verbindungen mit Sublimationstemperaturen zwischen größer oder gleich 120°C und kleiner oder gleich 600°C sich aus der Gasphase besonders homogen abscheiden lassen. Dies bedeutet, dass man besonders homogene Schichten erhalten kann. Die Molekulargewichte der Verbindungen lassen sich leicht aus den Summenformeln errechnen und die Sublimationstemperaturen werden nach dem im Stand der Technik bekannten Verfahren bestimmt werden.

In einer weiteren, bevorzugten Ausführungsform kann als Dotand Caesium-pentacyanocyclopentadienid verwendet werden.

In einem weiteren, erfindungsgemäßen Aspekt kann der Dotand in einer Schichtdicken-Konzentration von größer oder gleich 0,01 % und kleiner oder gleich 50 % in der organischen, elektronenleitenden Schicht vorliegen. Des Weiteren, besonders bevorzugt kann der Dotand in einer Schichtdicken-Konzentration von größer oder gleich 1,0 % und kleiner oder gleich 10 % in der organischen, elektronenleitenden Schicht vorliegen. Die Schichtdicken-Konzentration beschreibt dabei den volumenmäßigen Anteil des salzartigen Derivates an der gesamten, elektronenleitenden Schicht. Dieser Anteil lässt sich zum Beispiel anhand der Kationenverteilung innerhalb der Schicht, welche z.B. mittels einer energiedispersiven Röntgenstrukturanalyse (EDX) oder AAS (Atomabsorptionsspektroskopie) bestimmen wird, berechnen. In dem Falle, dass die Dotanden Charge-Transfer-Komplexe ausbilden, kann die Schichtdickenkonzentration mittels Messungen der UV-Absorption bestimmt werden.

Die Eigenschaften einer elektronenleitenden Schicht können durch den Zusatz eines salzartigen Dotanden verbessert werden. Der Dotand ist in der Lage ein Elektron an die Schicht abzugeben und kann somit zu einer Erhöhung der Leitfähigkeit der Schicht beitragen. Überraschenderweise hat sich gezeigt, dass Dotanden-Schichtdickenkonzentrationen oberhalb und unterhalb des oben angegebenen Bereiches zu schlechteren Leitfähigkeiten führen können. Ohne durch die Theorie gebunden zu sein führen niedrigere Dotanden-Konzentrationen zu einer ungenügenden Elektroneninjektion in die leitende Schicht und höhere Dotanden-Konzentrationen zu einem Mangel an Elektronentransportkomponenten innerhalb der Schicht. In beiden Fällen kann die Leitfähigkeit der elektronenleitenden Schicht für hocheffiziente organische Bauelemente unzureichend sein.

In einer weiteren Ausführungsform kann der Dotand reaktionsfähige Substituenten enthalten, welche über eine Vernetzungsreaktion nach dem Aufbringen zu einer kovalenten Bindung zwischen einzelnen Dotanden in der elektronenleitenden Schicht führt. Die zusätzlich eingebrachten kovalenten Bindungen zwischen den einzelnen Dotanden können zu einer mechanischen Stabilisierung der elektronenleitenden Schicht beitragen. Die mechanische und thermische Stabilität der Schicht kann durch die Vernetzung erhöht und dadurch die Lebensdauer des Bauteils verlängert werden. Die Vernetzung der einzelnen Dotanden kann dabei durch einen externen Trigger wie z.B. UV-Licht oder z.B. durch Wärmeeinstrahlung induziert werden. Im Rahmen eines Lösemittelprozesses kann die Vernetzung z.B. durch die Entfernung des Lösemittels oder chemische Reaktionsinitiatoren gestartet werden.

Weiterhin kann zur Herstellung einer organischen elektronenleitenden Schicht ein Verfahren verwendet werden, wobei die organische, elektronenleitende Schicht mittels eines Lösemittel- oder Sublimationsprozesses unter Verwendung salzartiger Cyclopentadien-Verbindungen auf ein Bauteil aufgebracht wird. Besonders bevorzugt wird der elektronenleitende Bereich mittels Gasphasenabscheidung, besonders bevorzugt mittels physikalischer Gasphasenabscheidung (PVD) erzeugt. In diesem Schritt kann der Dotand bevorzugt zusammen mit der elektronenleitenden Schicht abgeschieden werden. Beide Substanzen können dabei aus unterschiedlichen Quellen unter Einsatz thermischer Energie sublimiert werden. Mittels dieses Verfahrens erhält man besonders homogene und gleichmäßige Schichten. Lösemittelprozesse können bevorzugt so durchgeführt werden, dass die Komponenten der elektronenleitenden Schicht und der Dotand aus einem Lösemittel auf ein Substrat abgeschieden werden. Dies kann die Prozessführung vereinfachen und eine günstigere Herstellung ermöglichen.

Desweiteren kann das Verfahren zur Herstellung einer organischen elektronenleitenden Schicht zum Einsatz in einer organischen Solarzelle, einem organischen Transistor, einem licht-emittierenden, organischen Bauteil, einer organische Leuchtdiode und/oder einer organischen licht-emittierenden elektrochemischen Zelle verwendet werden. Bedingt durch die verbesserten elektrischen Eigenschaften der erfindungsgemäßen elektrischen Transportschicht, eigenen sich diese Schichten besonders zum Aufbau oben genannter organischer Bausteile.

Zusätzlich kann mittels des vorgestellten Verfahrens ein organisch elektronisches Bauelement enthaltend eine erfindungsgemäße elektronenleitende, organische Schicht hergestellt werden.

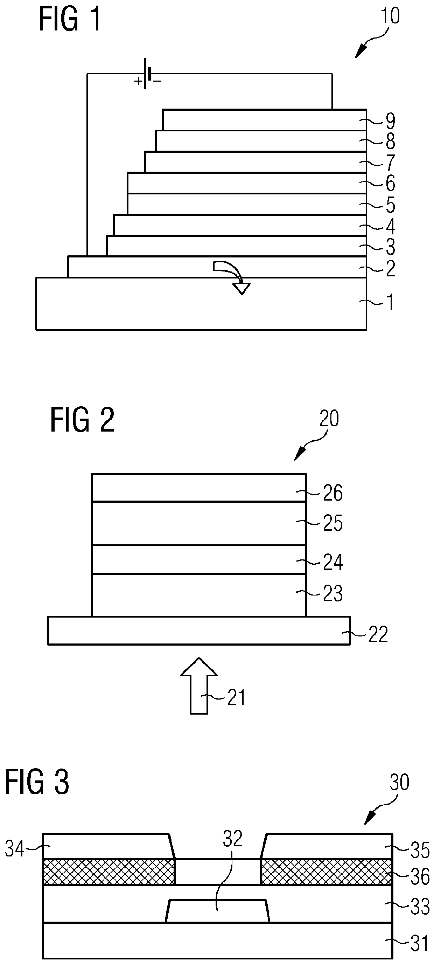

Der Aufbau organisch elektrischer Bauelemente wird nachfolgend anhand von Figuren näher erläutert. Die Figuren zeigen
Fig. 1 schematisch den Aufbau einer organischen Leuchtdiode (10). Die Leuchtdiode ist aufgebaut aus einer Glas-Schicht (1); Indium-Zinn-Oxid (ITO)-Schicht (2); Loch-InjektorSchicht (3); Loch-Transportschicht (HTL) (4); Emitter-Schicht (EML) (5); Loch-Blocker-Schicht (HBL) (6); ElektronenTransportschicht (ETL) (7); Elektronen-Injektorschicht (8)und einer Kathoden-Schicht (9);
Fig. 2 schematisch den Aufbau einer organischen Solarzelle mit PIN-Struktur (20), welche Licht (21) in elektrischen Strom umwandelt. Die Solarzelle besteht aus einer Schicht aus Indium-Zinn-Oxid (22); einer p-dotierten Schicht(23); einer Absorptions-Schicht (24); einer n-dotierten Schicht (25) und einer Metall-Schicht (26);
Fig. 3 schematisch einen möglichen Querschnitt eines organischen Feld-Effekt-Transistors (30). Auf einem Substrat (31) ist eine Gate-Elektrode (32), ein Gate-Dielektrikum (33), ein Source and Drain-Kontakt (34 + 35) und ein organischer Halbleiter (36) aufgebracht. Die schraffierten Stellen zeigen die Stellen an denen eine Kontaktdotierung hilfreich ist.

### Beispiele:

### I. Synthese von Pentaarylcyclopentadien

Die Synthese von Pentaarylcyclopentadien kann im Wesentlichen auf zwei unterschiedlichen Synthesewegen nach unten stehenden Reaktionsschemata erfolgen:

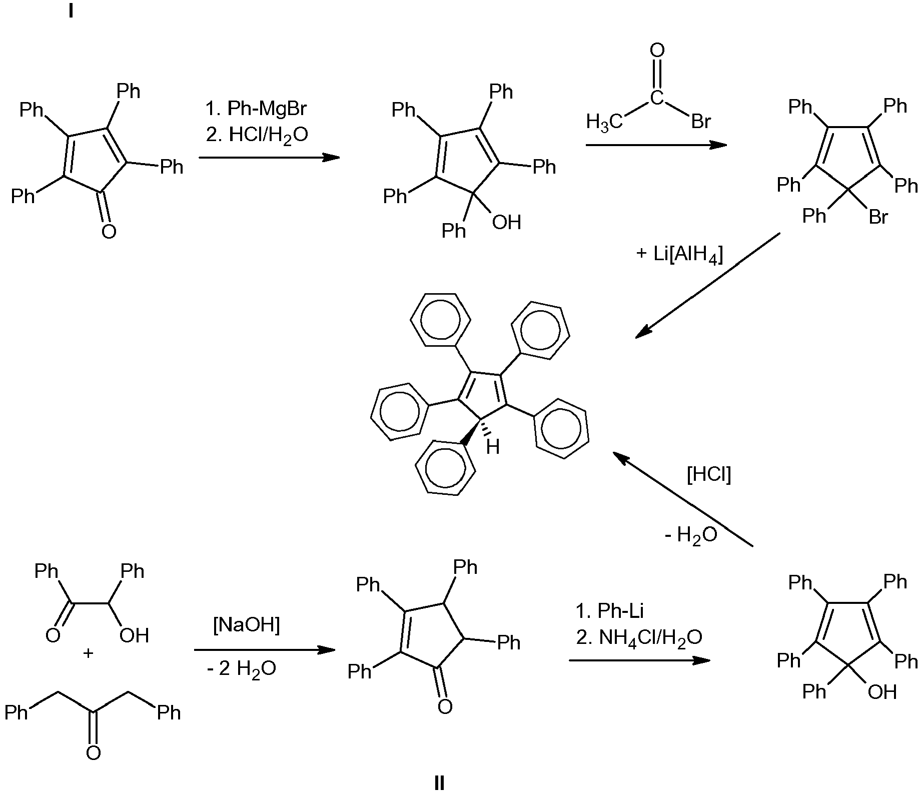

Der erste Reaktionsweg I erfolgt über Tetraarylcyclopentadienon als Ausgangssubstanz, wohingegen der zweite Reaktionsweg II über 2,3,4,5 Tetraarylcyclopenten-2-on als Ausgangssubstanz erfolgt.

### I. Syntheseweg ausgehend von Tetraarylcyclopentadienon

Die Synthese von Pentaarylcyclopentadien ausgehend von Tetraarylcyclopentadienon basiert auf den Arbeiten von Ziegler und Schnell (Ziegler et al., Liebigs Ann. Chem. 445 (1925), 266) und wurde in wesentlichen Verfahrensschritten modifiziert.

### Ia) 1,2,3,4,5-Pentaphenylcyclopenta-1,3-dien-5-ol

In einer Grignard-Reaktion wird ausgehend von Tetraarylcyclopentadienon und einem Überschuss an Aryl-Magnesiumbromid 1,2,3,4,5-Pentaarylcyclopenta-1,3-dien-5-ol erhalten. In einem weiteren Schritt wird 1,2,3,4,5-Pentaarylcyclopenta-1,3-dien-5-ol nicht wie bei Ziegler beschrieben durch Einleiten eines Bromwasserstoffstromes in eine Lösung des Alkohols in Eisessig erhalten, sondern durch die Reaktion des Alkohols mit Acetylbromid in Toluol. Diese Reaktion verläuft mit tertiären Alkoholen wie z.B. dem Triphenylmethanol besonders gut.

46,2 g (0,12 mol) Tetraphenylcyclopentadienon werden mit 0,61 mol Phenylmagnesium-Bromid in 400 ml Ether zu 1,2,3,4,5-Pentaphenylcyclopenta-1,3-dien-ol umgesetzt (Ausbeute 50.8 g (87 %); Fp.: 177-179°C, Lit.: 175-176°C , Elementaranalyse für C35H26O: gef.: C 90.98 %, H 5.59 %, ber.: C 90.88 %, H 5.66 %.)

### Ib) 5-Brom-1,2,3,4,5-pentaphenylcyclopenta-1,3-dien

Das Pentaarylcyclopenta-1,3-dien-5-ol reagiert unter Abspaltung von Bromwasserstoff zu 1,2,3,4,5-Pentaarylcyclopenta-1,3-dien-1-acetat. Dieser Ester ist bei Anwesenheit von Bromwasserstoff instabil. Unter Abspaltung von Essigsäure erhält man ein 1,2,3,4,5-Pentaaryl-cyclopentadienylkation, welches sich durch Aufnahme eines Bromidions stabilisiert. Mit einer Reaktionsführung unter einem Überschuss an Acetylbromid verläuft die Umsetzung quantitativ.

50.8 g (0.11 mol) 1,2,3,4,5-Pentaphenylcyclopenta-1,3-dien-5-ol werden in 200 ml Toluol suspendiert. Innerhalb von 20 Minuten werden bei Raumtemperatur 74 g (0,6 mol) Acetylbromid zugetropft und der Reaktionsansatz anschließend 2 Stunden unter Rückfluss gekocht. Gegen Ende der Reaktion werden noch 2 ml Methanol tropfenweise zugegeben. Überschüssiges Acetylbromid und Toluol werden im Vakuum abdestilliert. Das zurückbleibende Öl kristallisierte nach Zugabe von 100 ml Petrolether. Der orange Niederschlag wird abgesaugt, mit Petrolether nachgewaschen und getrocknet (Fp.: 183 - 185°C). Analysenreine orange Produkte werden durch Rekristallisation aus Toluol erhalten. (Ausbeute: 52,7 g (91 %); Fp.: 189 - 190°C, Lit.: 188 - 189°C; Elementaranalyse für C35H25Br: gef.: C 80.2 %, H 4.8 %, ber.: C 80.00 %, H 4.8 %).

### Ic) 1,2,3,4,5-Pentaphenylcyclopenta-1,3-dien

Anschließend wird das 5-Brom-1,2,3,4,5-Pentaarylcyclopenta-1,3-dien in Ether mit Lithiumaluminiumhydrid zum Pentaarylcyclopentadien-Kohlenwasserstoff reduziert (nach Houben-Weyl 4/1d Reduktion II Methoden der organischen Chemie (1981) Seite 397).

Zu einer Suspension von 11,5 g (0,3 mol) Li[AlH₄] in 150 ml Ether wird portionsweise eine Suspension von 52,6 g (0,1 mol) 5-Brom-1,2,3,4,5-pentaphenylcyclopenta-1,3-dien in 300 ml Ether unter Rühren zugegeben. Die entstehende leicht gelbgraue Suspension wird zur Vervollständigung der Reduktion noch 2 Stunden unter Rückfluss gekocht. Nach dem Abkühlen auf Raumtemperatur wird überschüssiges Li[AlH₄] zunächst mit Eiswasser und dann mit verdünnter Salzsäure hydrolysiert. Mit dem Rotationsverdampfer werden anschließend alle flüchtigen organischen Bestandteile aus dem Reaktionsgemisch abdestilliert. Das leicht gelbe Rohprodukt wird abgesaugt und mehrere Male mit Wasser gewaschen. Zur weiteren Reinigung wird es mit Toluol azeotrop getrocknet, filtriert und anschließend umkristallisiert (Ausbeute 37,3 g (84 %); Fp.: 253 - 256°C (je nach Ansatz), Lit.: 244 - 246; Elementaranalyse für C35H26: gef.: C 94.8 %, H 5.8 %; ber.: C 94.13 %, H 5.87 %; ¹H-NMR (200 MHz, CDCl3, TMS [ppm]): δ 7.25 - 6.92 (Multiplett, 25 Aromat-H), 5.07 (1 Acid-H): 13C-NMR (breitbandentkoppelt, 50 MHz, CDCl₃, TMS [ppm]): 146.5, 144.0, 136.2, 135.8, 130.1, 129.0, 128.5, 128.4, 127.8, 127.6, 126.7, 126.5, 126.3, 62.7 (s, sp3-C); MS-EI-Spektrum stimmt mit Literaturspektrum RMSD 5094-9 überein).

### II. Syntheseweg ausgehend von 2,3,4,5 Tetraarylcyclopenten-2-on

Nach Dielthey et al. (Dielthey, W., Quint, F., J. Prakt. Chem. 2 (1930), 139) wird ausgehend von Benzoin und 1,3 - Diphenylaceton (Dibenzylketon) 2,3,4,5-Tetraarylcyclopenten-2-on als Kondensationsprodukt erhalten. 2,3,4,5-Tetraarylcyclopenten-2-on reagiert mit einem Überschuss an Aryllithium zu 1,2,3,4,5-Pentaarylcyclopenta-2,4-dien-1-ol, welches sich anschließend nach Rio et al. (Rio, G. Sanz, Bull Soc. Chim. France 12 (1966) 3375) unter Eliminierung von Wasser zu sehr reinem Pentaarylcyclopentadien umsetzt.

### IIa. 1,2,3,4,5-Pentaphenylcyclopenta-1,3-dien

2,3,4,5-Tetraphenylcyclopenten-2-on reagiert mit einem Überschuss Phenyllithium zu 1,2,3,4,5-Pentaphenylcyclopenta-2,4-dien-1-ol. 1,2,3,4,5-Pentaphenylcyclopenta-1,3-dien entsteht anschließend durch Eliminierung von Wasser. Diese Methode liefert ebenfalls sehr reine Produkte.

1,2,3,4,5-Pentaphenylcyclopenta-1,3-dien wird aus 37,8 g (0,098 mol) 2,3,4,5-Tetraphenyl-cyclopenten-2-on und 0,5 mol Phenyllithium (aus 7 g (1 mol) Li und 78,5 g (0,5 mol) Brombenzol) in 300 ml Ether nach einer Literaturvorschrift von Rio und Sanz dargestellt und analog Methode I gereinigt. Die Umsetzung des 1,2,3,4,5-Pentaphenylcyclopenta-2,4-dien-1-ols zum 1,2,3,4,5-Pentaphenylcyclopenta-1,3-dien erfolgt dabei automatisch innerhalb der Umsetzung. Man erhält eine Ausbeute von 34,9 g (80 %) und das Produkt ist mit dem nach Methode I dargestellten C₅HPh₅ identisch.

### III. Darstellung der Salze der Cyclopentadien-Verbindungen am Beispiel der Caesium-Salze

Ca. 100 mg elementares Caesium (Fluka) werden mehrmals mit Hexan gewaschen, um evt. anhaftende Öle zu entfernen. 1 mmol der Cyclopentadien-Verbindungen wird im Vakuum getrocknet und in ca. 20 - 40 ml THF gelöst. Diese Lösung wurde zu dem gereinigten Caesium gegeben. Es entwickelt sich Wasserstoff. Die Suspension wird so lange gerührt (ca. 2 - 4 h), bis eine Färbung auftritt oder keine Wasserstoffentwicklung mehr zu beobachten ist. Die Lösung wird zur Entfernung überschüssigen Caesiums abfiltriert. Durch Abziehen des Lösungsmittels und anschließendem scharfen Trocknen werden die wasserfreien Caesium-Salze der Cyclopentadien-Verbindung erhalten.

### IV. Darstellung der Schichten

IV.1) Herstellung des Vergleichsmaterials

Auf einer ITO-(Indium-Tin-Oxide = Indium-dotiertes Zinnoxid) Elektrode wird durch thermisches Verdampfen eine 200 nm dicke Schicht des Elektronenleiters BCP (2,9-Dimethyl-4,7-diphenyl-1,10-phenanthroline) abgeschieden. Als Gegenelektrode wird eine 150 nm dicke Aluminiumschicht verwendet.

### IV.2) Herstellung organisch elektrisch leitfähiger Schichten mit Caesiumpentaphenylcyclopentadienid als Dotant

In drei weiteren Experimenten wird eine Caesiumpentaphenylcyclopentadienid in Konzentrationen von 2%, 5% und 10% relativ zur Verdampfungsrate des BCP in die elektrisch leitende Schicht eindotiert.

Im Rahmen einer physikalischen Charakterisierung erhält man für die Strom-Spannungs-Charakteristika der dotierten, organischen Bauelemente, dass die Stromdichte der dotierten Schichten bei gleicher Spannung deutlich oberhalb der des Vergleichssubstrates liegen. Dieser Effekt ist bei hinreichend kleinem Dotierungsgrad annähernd proportional zur Dotierungsstärke. Die Erhöhung der Stromdichte lässt somit auf eine Erhöhung der Ladungsträgerdichte und/oder -beweglichkeit schließen.

IV.3 Herstellung organisch elektrisch leitfähiger Schichten mit Rubidiumpenta(p-tolyl)cyclopentadienid als Dotant In drei weiteren Experimenten wird eine Rubidiumpenta(p-tolyl)cyclopentadienid in Konzentrationen von 2%, 5% und 10% relativ zur Verdampfungsrate des BCP eindotiert.

Im Rahmen einer physikalischen Charakterisierung erhält man für die Strom-Spannungs-Charakteristika der dotierten, organischen Bauelemente, dass die Stromdichte der dotierten Schichten bei gleicher Spannung deutlich oberhalb der des Vergleichssubstrates liegen. Dieser Effekt ist bei hinreichend kleinem Dotierungsgrad annähernd proportional zur Dotierungsstärke. Die Erhöhung der Stromdichte lässt somit auf eine Erhöhung der Ladungsträgerdichte und/oder -beweglichkeit schließen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden.

## Patentansprüche

1. Organische, elektronenleitende Schicht mit mindestens einem Dotanden zur Erhöhung der n-Leitfähigkeit der organischen Schicht,
**dadurch gekennzeichnet, dass** der Dotand ausgewählt ist aus der Gruppe der Salze der Cyclopentadien-Verbindungen nach Formel 1, 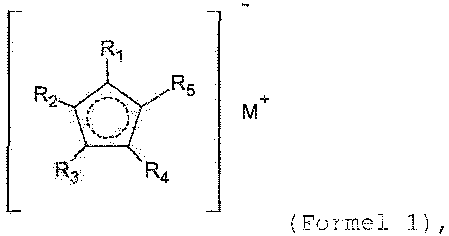 wobei M⁺ aus Formel 1 ausgewählt ist aus der Gruppe der Alkali-, Erdalkali-, Hauptgruppen-, Nebengruppen-, Lanthanoid-und Übergangsmetalle und die Substituenten R₁ bis R₅ unabhängig voneinander ausgewählt sind aus der Gruppe enthaltend -H, -D, Halogen, -CN, -NO₂, -OH, Amin, Ether, Thioether, Alkyl, Cycloalkyl, Acryl, Vinyl, Allyl, Aromaten, anellierte Aromaten und Heteroaromaten.

2. Die organische, elektronenleitende Schicht nach Anspruch 1, wobei der Dotand ausgewählt ist aus der Gruppe der nichtsubstituierten oder substituierten Pentaarylcyclopentadien-Salze.

3. Die organische, elektronenleitende Schicht nach einem der vorhergehenden Ansprüche, wobei die Schicht ein Metall-Kation M⁺ ausgewählt aus der Gruppe der Alkalimetalle umfassend Lithium, Natrium, Kalium, Rubidium und Caesium enthält.

4. Die organische, elektronenleitende Schicht nach einem der vorhergehenden Ansprüche, wobei die Schicht ein Metall-Kation M⁺ ausgewählt aus der Gruppe der schweren Alkalimetalle umfassend Rubidium und Caesium enthält.

5. Die organische, elektronenleitende Schicht nach einem der vorhergehenden Ansprüche, wobei der organische Teil des Dotanden innerhalb der organischen, elektronenleitenden Schicht mit einer Oxidationszahl von größer oder gleich -1 und kleiner oder gleich 0 vorliegt.

6. Die organische, elektronenleitende Schicht nach einem der vorhergehenden Ansprüche, wobei das Molekulargewicht der Salze der Cyclopentadienverbindungen größer oder gleich 175 g/mol und kleiner oder gleich 2000 g/mol und die Sublimationstemperaturen größer oder gleich 120 °C und kleiner oder gleich 600 °C sind.

7. Die organische, elektronenleitende Schicht nach einem der vorhergehenden Ansprüche, wobei der volumenmäßige Anteil des Dotanden an der gesamten, elektronenleitenden Schicht (Schichtdicken-Konzentration) größer oder gleich 0,01 % und kleiner oder gleich 50 % beträgt.

8. Verfahren zur Herstellung einer organischen elektronenleitenden Schicht nach einem der vorhergehenden Ansprüche 1 - 7, wobei die organische, elektronenleitende Schicht mittels eines Lösemittel- oder Sublimationsprozesses unter Verwendung salzartiger Cyclopentadien-Verbindungen auf ein Bauteil aufgebracht wird.

9. Verwendung eines Verfahrens nach Anspruch 8 zur Herstellung einer organischen elektronenleitenden Schicht zum Einsatz in einer organischen Solarzelle, einem organischen Transistor, einem licht-emittierenden, organischen Bauteil, einer organische Leuchtdiode und/oder einer organischen licht-emittierenden elektrochemischen Zelle.

10. Organisch elektronisches Bauelement enthaltend eine elektronenleitende, organische Schicht nach einem der Ansprüche 1 - 7.

## Claims

1. Organic electron-conducting layer having at least one dopant for increasing the n-conductivity of the organic layer,
**characterized in that** the dopant is selected from the group of the salts of the cyclopentadiene compounds of formula 1 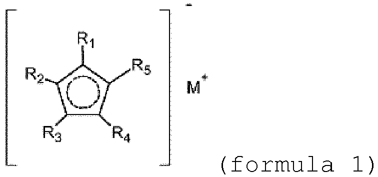 where M+ from formula 1 is selected from the group of the alkali metals, alkaline earth metals, main group metals, transition group metals, lanthanoid metals and transition metals and the substituents R₁ to R₅ are each independently selected from the group comprising -H, -D, halogen, -CN, -NO₂, -OH, amine, ether, thioether, alkyl, cycloalkyl, acryloyl, vinyl, allyl, aromatics, fused aromatics and heteroaromatics.

2. Organic electron-conducting layer according to Claim 1, wherein the dopant is selected from the group of the unsubstituted and substituted pentaarylcyclopentadiene salts.

3. Organic electron-conducting layer according to either of the preceding claims, wherein the layer contains a metal cation M⁺ selected from the group of the alkali metals comprising lithium, sodium, potassium, rubidium and cesium.

4. Organic electron-conducting layer according to any of the preceding claims, wherein the layer contains a metal cation M⁺ selected from the group of the heavy alkali metals comprising rubidium and cesium.

5. Organic electron-conducting layer according to any of the preceding claims, wherein the organic portion of the dopant is present within the organic electron-conducting layer with an oxidation number of greater than or equal to -1 and less than or equal to 0.

6. Organic electron-conducting layer according to any of the preceding claims, wherein the molecular weight of the salts of the cyclopentadiene compounds is greater than or equal to 175 g/mol and less than or equal to 2000 g/mol, and the sublimation temperatures are greater than or equal to 120°C and less than or equal to 600°C.

7. Organic electron-conducting layer according to any of the preceding claims, wherein the proportion by volume of the dopant in the overall electron-conducting layer (layer thickness concentration) is greater than or equal to 0.01% and less than or equal to 50%.

8. Process for producing an organic electron-conducting layer according to any of the preceding Claims 1-7, wherein the organic electron-conducting layer is applied to a component by means of a solvent or sublimation process using salt-type cyclopentadiene compounds.

9. Use of a process according to Claim 8 for production of an organic electron-conducting layer for use in an organic solar cell, an organic transistor, a light-emitting organic component, an organic light-emitting diode and/or an organic light emitting electrochemical cell.

10. Organic electronic component comprising an electron-conducting organic layer according to any of Claims 1-7.

## Revendications

1. Couche organique conductrice d'électrons ayant au moins au moins un dopant pour augmenter la conductivité n de la couche organique,
**caractérisé en ce que** le dopant est choisi dans le groupe des sels, des composés du cyclopentadiène suivant la formule 1 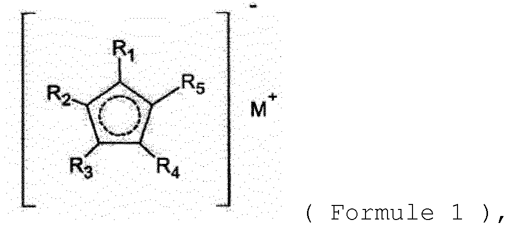 dans laquelle M⁺ dans la formule 1 est choisi dans le groupe des métaux alcalins, alcalino-terreux, de groupe principal, de groupe auxiliaire, de lanthanoïde et de transition et les substituants R₁ à R₅ sont choisis indépendamment les uns des autres dans le groupe comportant -H, -D, halogène, -CN, -NO₂, - OH, amine, étheroxyde, thioéther, alcoyle, cycloalcoyle, acryle, vinyle, allyle, aromatiques, aromatiques condensés et hétéroaromatiques.

2. Couche organique conductrice d'électrons suivant la revendication 1, dans laquelle le dopant est choisi dans le groupe des sels de pentaarylcyclopentadiène non substitués ou substitués.

3. Couche organique conductrice d'électrons suivant l'une des revendications précédentes, dans laquelle la couche contient un cation M⁺ métallique choisi dans le groupe des métaux alcalins, comprenant le lithium, le sodium, le potassium, le rubidium et le césium.

4. Couche organique conductrice d'électrons suivant l'une des revendications précédentes, dans laquelle la couche contient un cation M⁺ métallique choisi dans le groupe des métaux alcalins lourds, comprenant le rubidium et le césium.

5. Couche organique conductrice d'électrons suivant l'une des revendications précédentes, dans laquelle la partie organique du dopant, au sein de la couche organique conductrice d'électrons, est présente en ayant un degré d'oxydation supérieur ou égal à -1 et inférieur ou égal à 0.

6. Couche organique conductrice d'électrons suivant l'une des revendications précédentes, dans laquelle le poids moléculaire des sels des composés du cyclopentadiène est supérieur ou égal à 175 g/mol et inférieur ou égal à 2000 g/mol et les points de sublimation sont supérieurs ou égaux à 120°C et inférieurs ou égaux à 600°C.

7. Couche organique conductrice d'électrons suivant l'une des revendications précédentes, dans laquelle la proportion en volume du dopant dans toute la couche conductrice d'électrons (concentration en épaisseur de couche) est supérieure ou égale à 0,01 % et inférieure ou égale à 50 %.

8. Procédé de préparation d'une couche organique conductrice d'électrons suivant l'une des revendications précédentes 1 à 7, dans lequel on dépose sur un composant la couche organique conductrice d'électrons au moyen d'un processus par solvant ou par sublimation, en utilisant des composés du cyclopentadiène de type sel.

9. Utilisation d'un procédé suivant la revendication 8, pour préparer une couche organique conductrice d'électrons à utiliser dans une pile solaire organique, dans un transistor organique, dans un composant organique émettant de la lumière, dans une diode organique électroluminescente et/ou dans une pile électrochimique organique émettant de la lumière.

10. Composant électronique organique contenant une couche organique conductrice d'électrons suivant l'une des revendications 1 à 7.
